Europäisches Patentamt

(19) European Patent Office

Office européen des brevets

(11) Publication number: **0 202 025 B1**

(12) **EUROPEAN PATENT SPECIFICATION**

(45) Date of publication of patent specification: **18.07.90**

(51) Int. Cl.⁵: **G 11 C 11/24,** G 11 C 11/40, G 11 C 8/00

(21) Application number: **86302714.0**

(22) Date of filing: **11.04.86**

(54) Booster circuit.

(30) Priority: **13.04.85 JP 77547/85**

(43) Date of publication of application:
**20.11.86 Bulletin 86/47**

(45) Publication of the grant of the patent:
**18.07.90 Bulletin 90/29**

(84) Designated Contracting States:
**DE FR GB**

(56) References cited:
EP-A-0 055 136
US-A-4 382 194

PATENT ABSTRACTS OF JAPAN, vol. 6, no. 189
(E-133)1067r, 28th September 1982; & JP-A-57
101 425 (FUJITSU K.K.) 24-06-1982

IEEE JOURNAL OF SOLID-STATE CIRCUITS, vol.
SC-16, no. 5, October 1981, pages 492-498, IEEE,
New York, US; M. TANIGUCHI et al.: "Fully
boosted 64K dynamic RAM with automatic and
self-refresh"

(73) Proprietor: **FUJITSU LIMITED**
**1015, Kamikodanaka Nakahara-ku**
**Kawasaki-shi Kanagawa 211 (JP)**

(72) Inventor: **Nakano, Masao**
**Mezon Hisasue 506 473-4, Hisasue Takatsu-ku**
**Kawasaki-shi Kanagawa 213 (JP)**
Inventor: **Takemae, Yoshihiro**
**8-13-24-303, Akasaka**
**Minato-ku Tokyo 107 (JP)**
Inventor: **Sato, Kimiaki**
**4-11-35-204, Minamiazabu**
**Minato-ku Tokyo 106 (JP)**
Inventor: **Kodama, Nobumi**
**Fujitsu Dai 5 Nakahara-ryo, 708 Shimokodanaka**
**Nakahara-ku Kawasaki-shi Kanagawa 211 (JP)**

(74) Representative: **Billington, Lawrence Emlyn**
**et al**
**HASELTINE LAKE & CO Hazlitt House 28**
**Southampton Buildings Chancery Lane**
**London WC2A 1AT (GB)**

Courier Press, Leamington Spa, England.

**EP 0 202 025 B1**

(56) References cited:

IEEE INTERNATIONAL SOLID-STATE CIRCUITS
CONFERENCE, San Francisco, 22nd-24th
February 1984, vol. 27, conf. 31, pages
136,137,327, IEEE, New York, US; D. RINERSON
et al.: "512K EPROMs"

## Description

The present invention relates to a booster circuit. More particularly, it relates to a booster circuit in a semiconductor memory device.

When the memory capacity of a dynamic random access memory (D-RAM) is increased, a voltage of a word line must be boosted above a voltage $V_{cc}$ of a power source at a high speed, since memory cells connected to the word line increase, and thus increase a capacitance of the word line connected thereto. In addition, in a stacked-capacitor type RAM, the capacitance of the word line is greatly increased. On the other hand, the boosting of the word line voltage will contribute to an improvement of the resistance against a soft error.

Booster circuits have been applied to DRAM devices having a large number of memory cells, for example 256 Kbits or more. The boosting of the voltage is realized by providing a capacitor having a capacitance which may be several times that of the capacitance of the word line connected thereto. A DRAM of 256 Kbits has 1024 memory cells along one word line, but a DRAM of 1 Mbits has 2048, accordingly, in the 1 Mbits DRAM, the capacitance connected to the word line is increased by as much as twice that of the 256 Kbits DRAM. This means that, for boosting, a large capacitance of the above capacitor is required in the DRAM devices having a large number of memory cells. Accordingly, it would seem that these devices suffer from the disadvantages of a low integration of the DRAM device due to the capacitor used to provide the above capacitance having a large area, thus preventing a high integration, and a low speed response for fully changing the voltage in the capacitor in question.

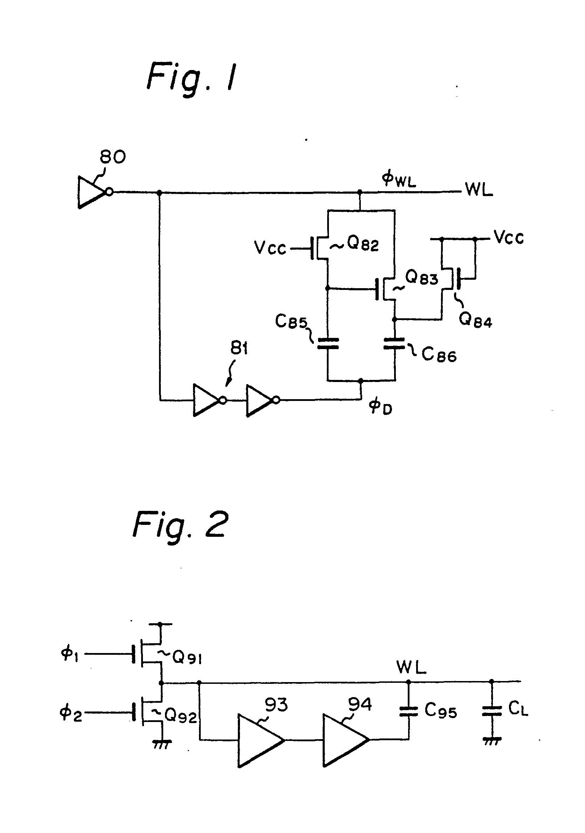

US—A—4,382,194 discloses a booster circuit as shown in the accompanying Figure 1, which is explained below.

JP—A—57-101425 discloses a booster circuit in which a load capacitor is charged both by a power supply voltage and by a coupling capacitor, the power supply voltage and coupling capacitor having a common switched path to the load capacitor.

An article in "IEEE International Solid-State Circuits Conference vol. 27 (1984)" by D. Rinerson et al entitled "512K EPROMs" discloses a pump circuit for programming an EPROM. Word lines are pumped to approximately 15V by a pump connected via a diode to an X-decoder, and a separate switched path connects the X-decoder to a power source voltage.

The defects of the prior art will be described later in detail with reference to the drawings.

It is desirable to provide a booster circuit having a small size capacitor for boosting and a low power consumption and high speed operation.

It is also desirable to provide a booster circuit, preferably applicable to a semiconductor memory device, for boosting a voltage of a word line of the device and improving integration of the device.

According to the present invention, there is provided a booster circuit for producing a boosted output signal comprising first and second power sources for suplying a power source voltage; a precharge capacitor for supplying a potential to form said boosted output signal;

and a first driver circuit connected between first and second power sources and including a first bootstrap circuit, for receiving first and second signals having exclusive logic levels and producing a first output signal in response to said first and second signals;

characterised by said precharge capacitor being operatively connected to receive said first output signal from said first driver circuit, so as to precharge when said second signal is supplied;

a second driver circuit connected between said first and second power sources, receiving said first and second signals, and including a second bootstrap circuit for producing a third output signal in response to said first and second signals, and a first switching circuit having a terminal connected to receive a second output signal from said precharge capacitor, and an output terminal for outputting said boosted output signal having a voltage level higher than said power source voltage, said first switching circuit switching to transfer said second output signal to said output terminal to form said boosted output signal in response to said third output signal;

a second switching circuit, separate from said first switching circuit and comprising a transistor connected between said first power source and said output terminal and operating in response to said first signal; and

a third switching circuit comprising a transistor connected between the first power source and the precharge capacitor for precharging the precharge capacitor when said second signal is supplied thereto; and in that

said second switching circuit is arranged so as to output a voltage to said output terminal in response to said first signal in advance of the switching of said first switching circuit.

The booster circuit preferably is applicable to a semiconductor memory device, for boosting a voltage of a word line at a high speed and improving integration.

Reference will now be made, by way of example, to the accompanying drawings, in which:

Figure 1 is a circuit diagram of a prior art boosting circuit;

Figure 2 is a circuit diagram of another prior art boosting circuit;

Figure 3 is a circuit diagram of still another prior art boosting circuit;

Figure 4 is a graph illustrating wave forms in the circuit in Figure 3;

Figure 5 is a circuit diagram of a boosting circuit of an embodiment in accordance with the present invention; and

Figure 6 is a graph illustrating wave forms in the circuit in Figure 5.

Before describing preferred embodiments of the present invention, a description will be given of the prior art for reference.

Figure 1 is a circuit diagram of a prior art word line voltage booster circuit disclosed in "Denshi Gigyutsu (Electronics Engineering)" Vol. 23, No. 3, pp 31. The circuit in Figure 1 consists of a word line signal generation circuit 80, a delay circuit 81, MOS transistors $Q_{82}$, $Q_{83}$, and $Q_{84}$, and capacitors $C_{85}$ and $C_{86}$. The precharge capacitor $C_{86}$ is provided to boost a voltage of the word line WL. When a word line voltage $\phi_{WL}$ is raised to $V_{CC}$, the transistor $Q_{82}$ is turned ON, precharging the capacitor $C_{85}$ from the word line WL. A load connected to the word line WL is reduced to half. The capacitor $C_{86}$ is precharged through the transistor $Q_{84}$. When $\phi_D$ is raised to $V_{CC}$, the transistor $Q_{83}$ is turned ON, superimposing the voltage precharged in the capacitor $C_{86}$ onto the voltage of $V_{CC}$—$V_{TH}$. $V_{TH}$ represents a threshold voltage of the transistor.

However, in the circuit of Figure 1, the capacitor $C_{85}$ having a capacitance less than the capacitor $C_{86}$ is connected to the word line WL, in addition to capacitors of the memory cells. Accordingly, the reduction of the power consumption in and the speed up of the circuit are still limited.

Figure 2 is a circuitg diagram of another prior art word line voltage booster circuit disclosed in Nikkei Electronics, Oct. 24, 1983, pp. 185. The circuit shown in Figure 2 consists of MOS transistors $Q_{91}$ and $Q_{92}$, normal bootstrap buffers 93 and 94, and a precharge capacitor $C_{95}$. A capacitor $C_L$ represents a capacitor of the memory cells as a load.

Since the precharge capacitor $C_{95}$ is directly connected to the word line WL, a load of the transistor $Q_{91}$ is increased, the operating speed of the circuit is slow.

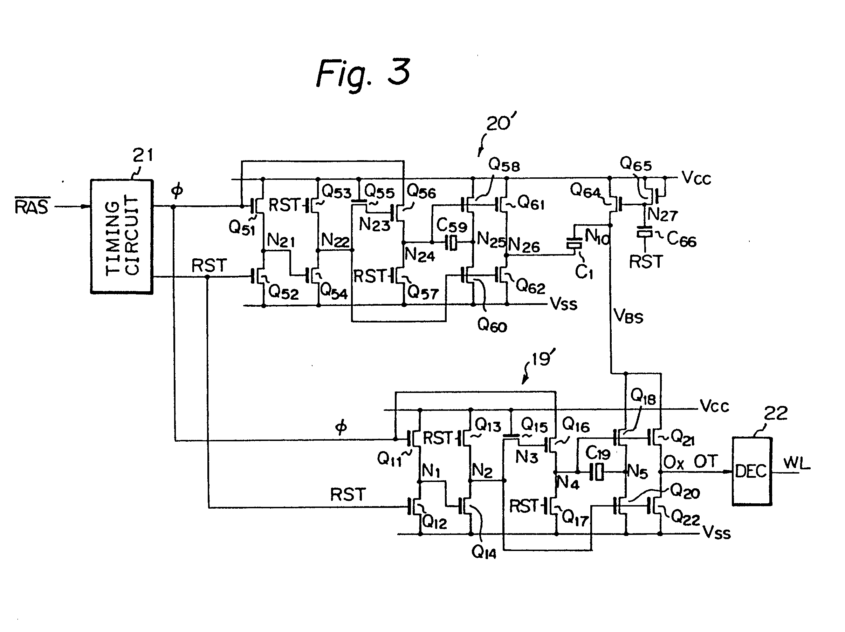

Figure 3 shows still another prior art word line voltage booster circuit consisting of a first driver circuit 20', a second driver circuit 19', and a precharge capacitor $C_1$ provided between these circuits 20' and 19'. The driver circuits 19' and 20' receive a clock signal $\phi$ and a reset signal RST from a timing circuit 21 which outputs the signals $\phi$ and RST in response to a row address select $\overline{RAS}$ signal. An output OT of the driver circuit 19 is supplied to a word line WL through a row decoder 22.

The driver circuit 19' consists of MOS transistors $Q_{11}$ to $Q_{22}$ and a bootstrap capacitor $C_{19}$. The driver circuit 20' consists of MOS transistors $Q_{51}$ through $Q_{65}$, which are interconnected between the voltage sources $V_{CC}$ and $V_{SS}$, anb a bootstrap capacitor $C_{59}$ and a capacitor $C_{66}$. References $N_1$ to $N_5$ and $N_{21}$ to $N_{27}$ indicate nodes.

In Figure 3, the capacitor $C_1$ for precharging the voltage is provided between the node $N_{26}$ and a source of the transistor $Q_{64}$ connected to drains of the transistors $Q_{18}$ and $Q_{21}$. The precharge capacitor $C_1$ is not directly connected to the word line, since it is cut off by the transistor $Q_{21}$ in a reset mode. Accordingly, the circuit shown in Figure 3 is beneficial to the problem of the circuit shown in Figure 2. In addition, a capacitor corresponding to the capacitor $C_{85}$ in Figure 1 is not provided in the circuit shown in Figure 3, and accordingly, the circuit shown in Figure 3 is beneficial to the problems of the circuit shown in Figure 1.

However, the circuit shown in Figure 3 still suffers from disadvantages which will be described later.

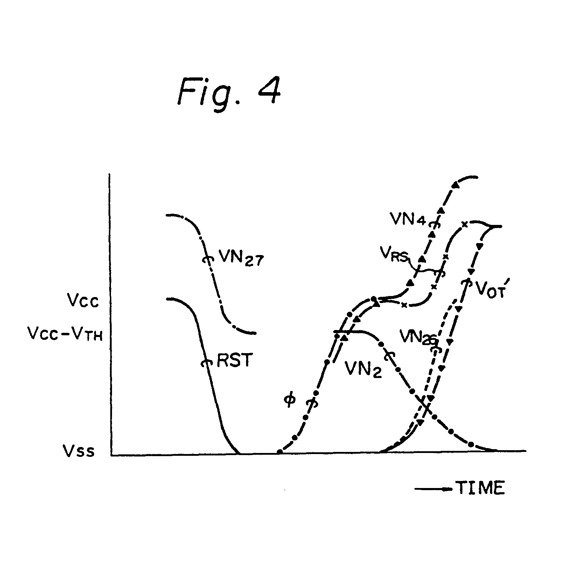

The operation of the circuit in Figure 3 will be described with reference to the various voltage wave forms in Figure 4. At first, the reset signal RST, which is one of the input signals to the circuit 20', remains at the "H" level, and the signal $\phi$, which is another input to the circuit 20', remains at the "L" level. Thus, the transistor $Q_{52}$ is kept ON, the transistor $Q_{51}$ is kept OFF, the node N21 is kept "L", the transistor $Q_{54}$ is kept OFF, and the transistor $Q_{53}$ is kept ON. Therefore, the nodes N22 and N23 are kept "H", and accordingly, the gate capacitance of the transistor $Q_{56}$ is charged up and the transistors $Q_{60}$ and $Q_{62}$ are kept ON. In addition, the node N24 is kept "L", and therefore the transistors $Q_{58}$ and $Q_{61}$ are kept OFF and the nodes N25 and N26 are kept "L". Furthermore, the node N27 is kept at the "HH" level, higher than the normal "H" level, due to the bootstrap effect according to the MOS capacitor $C_{66}$ and the signal RST so that the transistor $Q_{64}$ is kept fully ON. Therefore, the MOS capacitor $C_1$ is charged up at the level of the voltage source $V_{CC}$. Thus, at this stage, the output voltage $V_{BS}$ of the circuit 20' is kept at the $V_{CC}$ level.

Under the above-mentioned condition, when the signal RST falls, the potential $VN_{27}$ of the node N27 falls to a level lower than the $V_{CC}$ level by the threshold voltage $V_{TH}$ of the transistor $Q_{65}$, and the MOS capacitor $C_{66}$ is charged up to this potential ($V_{CC}$—$V_{TH}$) so that any charge lost in the capacitor $C_{66}$ while the bootstrap effect is being carried out is compensated. In addition, the output voltage $V_{BS}$, which has been kept at the $V_{CC}$ level, is disconnected from the voltage source $V_{CC}$ because the transistor $Q_{64}$ is turned OFF. This falling of the signal RST is effected before the rise of the signal $\phi$. When the signal $\phi$ rises after the falling of the signal RST, the transistor $Q_{51}$ is turned ON, the $Q_{52}$ is kept OFF, the node N21 is turned to "H", the transistor $Q_{54}$ is turned ON, the transistor $Q_{53}$ is kept OFF, the node N22 is turned to "L", the transistors $Q_{56}$, $Q_{60}$, $Q_{62}$ are turned OFF, and the transistor $Q_{57}$ is kept OFF. Therefore, the node N24 receiving the signal $\phi$ because the transistor $Q_{56}$ is turned ON is turned to "H", the transistors $Q_{58}$ and $Q_{61}$ are turned ON, and the nodes N25 and N26 are turned to "H". Since the MOS capacitor $C_1$ is charged up at the voltage source $V_{CC}$ as described above, the output voltage $V_{BS}$ is pushed above the voltage source $V_{CC}$ as shown in Figure 4 when the mode N26 rises to the level of $V_{CC}$ due to the bootstrap effect of the MOS capacitor $C_{59}$.

While in the circuit 19', when the signal $\phi$ rises, the transistor $Q_{11}$ is turned ON, the transistor $Q_{12}$ is turned OFF, the node N1 is turned to "H", the

transistor $Q_{14}$ is turned ON, and the transistor $Q_{13}$ is kept OFF, and accordingly, the node N2 falls to the "L" level. Thus, the transistors $Q_{20}$ and $Q_{22}$ are turned OFF. Further, at the period between the signal $\phi$ rise and the node N3 charging, the transistor $Q_{16}$ is kept ON, the transistor $Q_{17}$ is kept OFF, and accordingly, the node N4 rises together with the signal $\phi$. Accordingly, the transistors $Q_{18}$ and $Q_{21}$ are turned ON and are still more fully turned ON due to the bootstrap effect according to the MOS capacitor $C_{19}$. Therefore, the levels of the node N5 and the output OT rise rapidly above the voltage source $V_{cc}$ following the output voltage $V_{BS}$ which is pushed up to the "HH" level, as shown in Figure 4.

The capacitor $C_1$ is charged up before the rising of the signal $\phi$, and the transistor $Q_{64}$ in the charging circuit for the capacitor $C_1$ is turned OFF so that the output $V_{BS}$ is pushed up through the capacitor $C_1$ by the rising of the node N26 in response to the rising of the signal $\phi$, and the output voltage $V_{BS}$ is increased. Thus, the circuit of Figure 3 has an advantage in that there is no delay in operation. Further, since the capacitor $C_1$ is used as a voltage supply to the signal $\phi$ and is necessary for charging up the parasitic capacity accompanying the signal line of $\phi$, the capacity of the capacitor $C_1$ should be relatively large. Because the capacitor $C_1$ hs been charged up through the transistor $Q_{64}$ preceding the rising of the signal $\phi$, the large capacity of the capacitor $C_1$ does not cause a delay in operation. Accordingly, the access time of the memory device can be decreased by speeding up the rising transition of the output OT.

However, in the circuit shown in Figure 3, a charge accumulated in the capacitor $C_1$ is all output, and accordingly, if an even higher boosted voltage output to the word line is required in response to the increasing memory capacitor, such as a 1 mega bit RAM device, an area forming the capacitor $C_1$ having a capacitance which may be several times that of a load capacitance must be greatly increased. On the other hand, apparently the area forming the capacitor must be minimized due to the requirements of high integration and high density, etc. That is, the circuit in Figure 3 encounters a problem of antonymity.

An embodiment of the present invention will now be described.

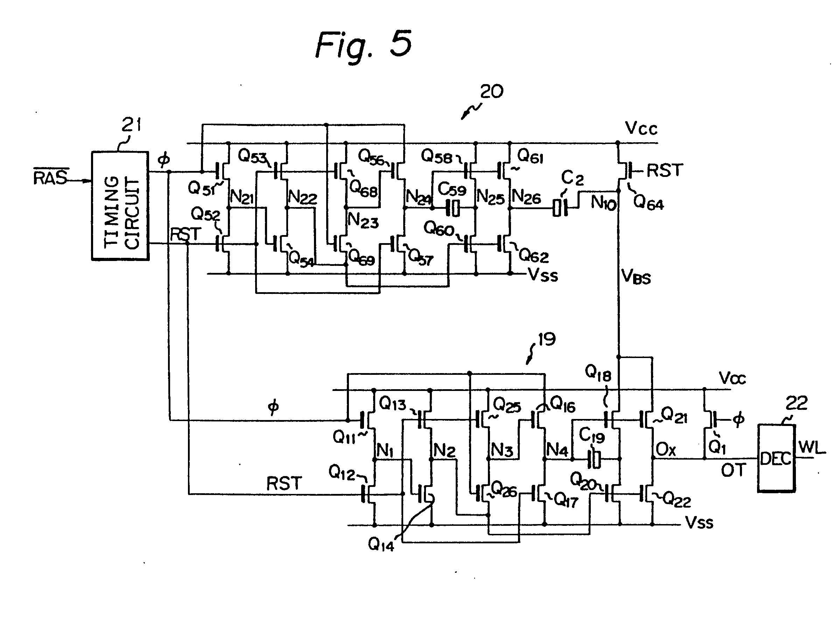

Referring to Figure 5, a booster circuit includes a first driver circuit 20, a second driver circuit 19, a precharge capacitor $C_2$, and an additional MOS transistor $Q_1$.

The first driver circuit 20 consists of MOS transistors $Q_{51}$ to $Q_{54}$, $Q_{56}$ to $Q_{64}$, $Q_{68}$ and $Q_{69}$, and a bootstrap capacitor $C_{59}$. The first driver circuit 20 is similar to the driver circuit 20' in Figure 3. The transistors $Q_{68}$ and $Q_{69}$ are provided instead of the transistor $Q_{55}$ in Figure 3 however, the principle of the operation of the driver circuit 20 is similar to that of the driver circuit 20' set forth above. In Figure 5, the transistor $Q_{65}$ and the capacitor $C_{66}$ in Figure 3 are added, and the reset signal supplied to a gate of the transistor $Q_{64}$ in Figure 5 may be regarded as a signal having the same nature as the node $N_{27}$ in Figure 3, set forth above.

Similarly, the driver circuit 19 has a same circuit construction as that of the driver circuit 19' in Figure 3, except that MOS transistors $Q_{25}$ and $Q_{26}$ are provided instead of the transistor $Q_{15}$ in Figure 3.

The precharge capacitor $C_2$ is provided in a same way as the capacitor $C_1$ in Figure 3, and thus the basic function of the capacitor $C_2$ is identical to that of the capacitor $C_1$.

The transistor $Q_1$ is added between the $V_{cc}$ and an output terminal $O_X$ of the output OT. The transistor $Q_1$ receives the clock signal $\phi$ at a gate thereof.

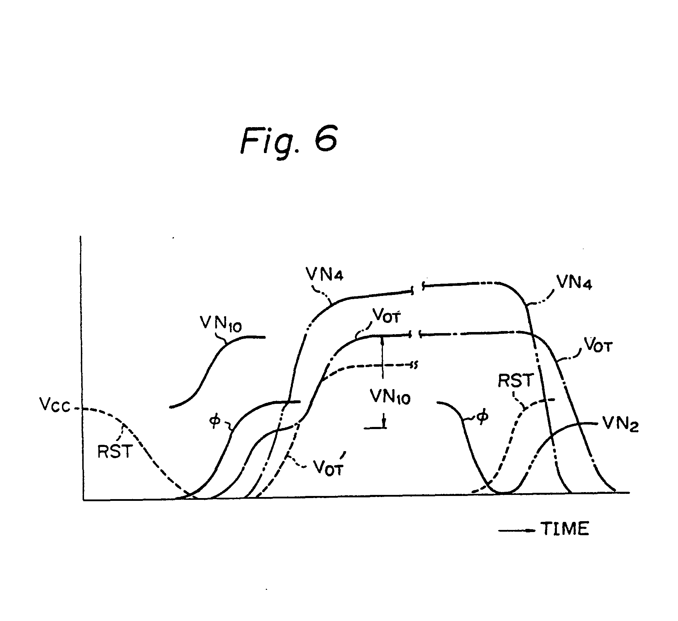

The operation of the circuit in Figure 5 will be described with reference to Figure 6.

When a $\overline{RAS}$ signal is not supplied to the timing circuit 21, in a reset mode, the timing circuit 21 outputs the reset signal RST having a high level, and the node $N_{10}$ is then precharged, as set forth above. The duration of the reset mode is normally long enough to fully precharge the voltage in the precharge capacitor $C_2$.

Upon receipt of the RAS signal, the timing circuit 21 causes a fall in the reset signal RST and a rise in the clock signal $\phi$, the reset signal RST and the clock signal being exclusive even if in a transition state.

By increasicg the clock signal $\phi$, a voltage $VN_{10}$ at the node $N_{10}$ will be further raised to the voltage $V_{cc}$, and a voltage $VN_4$ at the node $N_4$ is raised due to the bootstrap effect of the capacitor $C_{19}$. When the voltage $VN_4$ reaches a predetermined level sufficient to fully turn ON the transistor $Q_{21}$, the voltage $VN_{10}$ at the node $N_{10}$ is output to the output terminal $O_X$. At the same time, the clock signal $\phi$ reaches the level $V_{cc}$, and accordingly, the transistor $Q_1$ is also fully turned ON. Consequently, the voltage $V_{OT}$ at the output terminal $O_X$ is superimposed onto the voltage of $V_{cc}$ through the transistor $Q_1$, to the voltage from the node $N_{10}$ through the transistor $Q_{21}$.

The bootstrap circuit consisting of the capacitor $C_{59}$ and the transistors $Q_{58}$ and $Q_{61}$ has a feature of fully discharging the charge stored in the precharge capacitor $C_2$ to the output terminal $O_X$ through the transistor $Q_{21}$ in an operation mode when the clock signal is enable. The bootstrap circuit including the capacitor $C_{19}$ and the transistor $Q_{18}$ has a feature of fully turning ON the transistor $Q_{21}$ in the operation mode.

In the reset mode, the capacitor $C_2$ is precharged, however, the capacitor $C_2$ is cut off from the word line WL by the transistor $Q_{21}$. The transistor $Q_1$ is also turned OFF. Accordingly, the output of voltage $V_{OT}$ at the terminal $O_X$ is the voltage of $V_{SS}$, which may be zero volt, in the reset mode. While, in the operation mode, the superimposed voltage of the precharged voltage of the precharge capacitor $C_2$ and the voltage of $V_{cc}-V_{TH}$, which may be 4 volts, i.e., the boosted voltage, may appear at the output terminal $O_X$ and be output to the word line WL through the decoder 22.

Apparently, the driver circuit 20 functions as a precharge circuit for the capacitor $C_2$, and the driver circuit 19 functions as a switching circuit for outputting or cutting the precharged voltage. The additional transistor $Q_1$ functions as a switching circuit for superimposing the voltage $V_{cc}$ onto the precharge voltage.

When the capacitance of the precharge capacitor $C_2$ in Figure 5 is identical to that of the capacitor $C_1$, apparently, the voltage $V_{OT}$ at the output terminal $O_X$ is higher than that of the voltage $V_{OT}'$, shown by a dotted line in Figure 6 and corresponding to a curve $V_{OT}'$ in Figure 4, by the voltage of $V_{cc}$. In other words, the circuit in Figure 5 may further boost the output voltage $V_{OT}$ higher than that boosted by the circuit in Figure 3, by providing a single transistor $Q_1$, when the capacitances of the capacitors $C_1$ and $C_2$ are identical. An area forming the transistor $Q_1$ is considerably smaller than that of the precharge capacitor. Accordingly, high boosting may be achieved without reducimg the integration of the DRAM device.

To the contrary, when the boosting voltage equal to that in Figure 3 is required, the capacitor $C_2$ may be greatly reduced compared to the capacitor $C_1$. This will contribute to the high integration of the DRAM device.

In the above embodiment, the booster circuit was described with reference to the RAM device, for boosting the word line of the device, however, the booster circuit may be also applied to other devices.

Many widely differdnt embodiments of the present invention may be constructed without departing from the scope of the present invention. It should be understood that the present invention is not limited to the specific embodiments described in this specification, except as defined in the appended claims.

**Claims**

1. A booster circuit for producing a boosted output signal comprising first ($V_{cc}$) and second ($V_{ss}$) power sources for supplying a power source voltage; a precharge capacitor ($C_2$) for supplying a potential to form said boosted output signal; and a first driver circuit (20) connected between said first and second power sources and including a first bootstrap circuit ($C_{59}$, $Q_{58}$, $Q_{61}$), for receiving first ($\phi$) and second (RST) signals having exclusive logic levels and producing a first output signal in response to said first and second signals; characterised by:
said precharge capacitor ($C_2$) being operatively connected to receive said first output signal from said first driver circuit, so as to precharge when said second signal is supplied;
a second driver circuit (19) connected between said first and second power sources, receiving said first and second signals, and including a

second bootstrap circuit ($C_{19}$ and $Q_{18}$) for producing a third output signal in response to said first and second signals, and a first switching circuit ($Q_{21}$) having a terminal connected to receive a second output signal from said precharge capacitor, and an output terminal for outputting said boosted output signal having a voltage level higher than said power source voltage, said first switching circuit switching to transfer said second output signal to said output terminal to form said boosted output signal in response to said third output signal;
a second switching circuit, separate from said first switching circuit and comprising a transistor ($Q_1$) connected behween said first power source and said output terminal operating in response to said first signal ($\phi$); and
a third switching circuit comprising a transistor ($Q_{64}$) connected between the first power source ($V_{cc}$) and the precharge capacitor ($C_2$) for precharging the precharge capacitor when said second signal is supplied thereto; and in that
said second switching circuit is arranged so as to output a voltage to said output terminal in response to said first signal in advantage of the switching of said first switching circuit.

2. A booster circuit according to Claim 1, wherein said first switching circuit comprises a transistor ($Q_{21}$).

3. A booster circuit according to Claim 2, wherein said third output signal of said second bootstrap circuit has a voltage level high enough to fully turn ON said transistor ($Q_{21}$) of said first switching circuit.

4. A booster circuit according to Claim 2 or 3, wherein said first output signal of said first bootstrap circuit ($C_{59}$, $Q_{58}$, $Q_{61}$) has a voltage level high enough to fully output said voltage in said precharge capacitor ($C_2$) to said output terminal through said transistor ($Q_{21}$) in said first switching circuit.

5. A booster circuit according to any preceding claim, wherein said voltage of said output terminal has a level approximately the same as the level of said second power source ($V_{ss}$) when said second signal is supplied to said second driver circuit (19).

6. A booster circuit according to any preceding claim, wherein said second signal has an enable state longer than that of said first signal.

7. A dynamic metal insulation semiconductor memory device comprising a booster circuit according to any preceding claim, further comprising:
a timing circuit (21) generating said first and second signals in respónse to a memory access signal (RAS); and a word line (WL) operatively connected to said output terminal through a decoder (22), said output at said output terminal being supplied to said word line.

**Patentansprüche**

1. Spannungserhöherschaltung zur Erzeugung eines erhöhten Ausgangssignals, mit ersten (Vcc) und zweiten (Vss) Energiequellen zur Lieferung einer Energiequellenspannung; einem Vorlade-Kondensator ($C_2$), zum Liefern eines Potentials, um das genannte erhöhte Ausgangssignal zu bilden;

und einer ersten Treiberschaltung (20), die zwischen den genannten ersten und zweiten Energiequellen angeschlossen ist und eine erste Bootstrap-Schaltung ($C_{59}$, $Q_{58}$, $Q_{61}$) enthält, um erste ($\phi$) und zweite (RST) Signale zu empfangen, die exklusive Logikpegel haben, und ein erstes Ausgangssignal in Abhängigkeit von den genannten ersten und zweiten Signalen zu erzeugen; dadurch gekennzeichnet, daß

der genannte Vorlade-Kondensator ($C_2$) wirkungsmäßig verbunden ist, um das genannte erste Ausgangssignal von der genannten ersten Treiberschaltung zu empfangen, um so vorzuladen, wenn das genannte zweite Signal zugeführt wird, und durch

eine zweite Treiberschaltung (19), die zwischen den genannten ersten und zweiten Energiequellen verbunden ist, erste und zweite Signale empfängt und eine zweite Bootstrap-Schaltung ($C_{19}$ und $Q_{18}$) enthält, um ein drittes Ausgangssignal in Abhängigkeit von den genannten ersten und zweiten Signalen zu erzeugen, und einen ersten Schaltkreis ($Q_{21}$), der einen Anschluß hat, der angeschlossen ist, um eine zweites Ausgangssignal von dem genannten Vorlade-Kondensator zu empfangen, und einen Ausgangsanschluß, um das erhöhte Ausgangssignal auszugeben, welches einen Spannungspegel hat, der höher als derjenige der genannten Energiequellenspannung ist, wobei der erste Schaltkreis schaltet, um das genannte zweite Ausgangssignal an den genannten Ausgangsanschluß zu übertragen, um das spannungserhöhte Ausgangssignal in Abhängigkeit von dem genannten dritten Ausgangssignal zu bilden;

einen zweiten Schaltkreis, separat von dem genannten ersten Schaltkreis, und mit einem Transistor ($Q_1$), der zwischen der genannten ersten Energiequelle und dem genannten Ausgangsanschluß verbunden ist und in Abhängigkeit von dem genannten ersten Signal ($\phi$) arbeitet; und

einen dritten Schaltkreis, der einen Transistor ($Q_{64}$) umfaßt, der zwischen der genannten ersten Energiequelle (Vcc) und dem Vorlade-Kondensator ($C_2$) verbunden ist, um den Vorlade-Kondensator vorzuladen, wenn das genannte zweite Signal diesem zugeführt wird; und daß

der genannte zweite Schaltkreis so angeordnet ist, daß er eine Spannung an den genannten Ausgangsanschluß in Abhängigkeit von dem genannten ersten Signal vor dem Schalten des genannten ersten Schaltkreises abgibt.

2. Spannungserhöherschaltung nach Anspruch 1, bei der der genannte erste Schaltkreis einen Transistor ($Q_{21}$) umfaßt.

3. Spannungserhöherschaltung nach Anspruch 2, bei der das genannte dritte Ausgangssignal der genannten zweiten Bootstrap-Schaltung einen Spannungspegel hat, der hoch genug ist, um den

genannten Transistor ($Q_{21}$) des genannten ersten Schaltkreises vollständig auf EIN zu schalten.

4. Spannungserhöherschaltung nach Anspruch 2 oder 3, bei der das genannte erste Ausgangssignal der genannten ersten Bootstrap-Schaltung ($C_{59}$, $Q_{58}$, $Q_{61}$) einen Spannungspegel hat, der hoch genug ist, um die genannte Spannung in dem genannten Vorlade-Kondensator ($C_2$) durch den genannten Transistor ($Q_{21}$) in dem genannten ersten Schaltkreis vollständig an den genannten Ausgangsanschluß abzugeben.

5. Spannungserhöherschaltung nach einem der vorhergehenden Ansprüche, bei der die genannte Spannung des genannten Ausgangsanschlusses einen Pegel hat, der angenähert derselbe wie der Pegel der genannten zweiten Energiequelle (Vss) ist, wenn das genannte zweite Signal der genannten zweiten Treiberschaltung (19) zugeführt wird.

6. Spannungserhöherschaltung nach einem der vorhergehenden Ansprüche, bei der das zweite Signal einen Aktivierungszustand hat, der länger als derjenige des genannten ersten Signals ist.

7. Dynamische Metall-Isolations-Halbleiterspeichervorrichtung mit einer Spannungserhöherschaltung nach einem der vorhergehenden Ansprüche, ferner mit:

einer Zeitschaltung (21), welche die genannten ersten und zweiten Signale in Abhängigkeit von einem Speicherzugriffssignal (RAS) erzeugt; und einer Wortleitung (WL), die wirkungsmäßig über einen Decoder (22) mit dem genannten Ausgangsanschluß verbunden ist, wobei der genannte Ausgang an dem genannten Ausgangsanschluß der genannten Wortleitung zugeführt wird.

**Revendications**

1. Circuit de suramplification destiné à produire un signal de sortie suramplifié, comprenant une première source d'alimentation électrique ($V_{cc}$) et une deuxième source d'alimentation électrique ($V_{ss}$) servant à fournir un potentiel de source d'alimentation électrique; un condensateur de précharge ($C_2$) servant à fournir un potentiel afin de former ledit signal de sortie suramplifiée; et un premier circuit d'excitation (20) connecté entre lesdites première et deuxième sources d'alimentation électrique et comportant un premier circuit d'amorçage ($C_{59}$, $Q_{58}$, $Q_{61}$), servant à recevoir un premier signal ($\phi$) et un deuxième signal (RST) possédant des niveau logiques exclusifs et à produire un premier signal de sortie en réponse auxdits premier et deuxième signaux; caractérisé en ce que:

ledit condensateur de précharge ($C_2$) est fonctionnellement connecté de façon à recevoir ledit premier signal de sortie de la part dudit premier circuit d'excitation, afin de se précharger lorsque ledit deuxième signal est fourni;

un deuxième circuit d'excitation (19) connecté entre lesdites première et deuxième sources d'alimentation électrique, recevant lesdits premier et deuxième signaux, et comportant un deuxième circuit d'amorçage ($C_{19}$ et $Q_{18}$) servant à produire

un troisième signal de sortie en réponse auxdits premier et deuxième signaux, un premier circuit de commutation (Q$_{21}$) possédant une borne connectée de façon à recevoir un deuxième signal de sortie de la part dudit condensateur de précharge, et une borne de sortie servant à délivrer ledit signal de sortie suramplifié possédant un niveau de tension supérieur à celui de ladite tension de source d'alimentation électrique, ledit premier circuit de commutation commutant de façon à transférer ledit deuxième signal de sortie à ladite borne de sortie afin de former ledit signal de sortie suramplifié en réponse audit troisième signal de sortie;

un deuxième circuit de commutation, séparé dudit premier circuit de commutation et comprenant un transistor (Q$_1$) connecté entre ladite première source d'alimentation électrique et ladite borne de sortie et fonctionnant en réponse audit premier signal ($\phi$); et

un troisième circuit de commutation comprenant un transistor (Q$_{64}$) connecté entre ladite première source d'alimentation électrique (V$_{cc}$) et le condensateur de précharge (C$_2$) afin de précharger le condensateur de précharge lorsque ledit deuxième signal lui est fourni; et en ce que

ledit deuxième circuit de commutation est conçu de façon à délivrer une tension à ladite borne de sortie en réponse audit premier signal préalablement à la commutation dudit premier circuit de commutation.

2. Circuit de suramplification selon la revendication 1, où ledit premier circuit de commutation comprend un transistor (Q$_{21}$).

3. Circuit de préamplification selon la revendication 2, où ledit troisième signal de sortie dudit deuxième circuit d'amorçage possède un niveau de tension suffisamment élevé pour rendre complètement conducteur ledit transistor (Q$_{21}$) dudit premier circuit de commutation.

4. Circuit de suramplification selon la revendication 2 ou 3, où ledit premier signal de sortie dudit premier circuit d'amorçage (C$_{59}$, Q$_{58}$, Q$_{61}$) possède un niveau de tension suffisamment élevé pour délivrer complètement ladite tension contenue dans ledit condensateur de précharge (C$_2$) à ladite borne de sortie via ledit transistor (Q$_{21}$) dudit premier circuit de commutation.

5. Circuit de suramplification selon l'une quelconque des revendications précédentes, où ladite tension de ladite borne de sortie possède au niveau approximativement égal au niveau de ladite deuxième source d'alimentation électrique (V$_{ss}$) lorsque ledit deuxième signal est fourni audit deuxième circuit d'excitation (19).

6. Circuit de suramplification selon l'une quelconque des revendications précédentes, où ledit deuxième signal possède un état de validation plus long que celui dudit premier signal.

7. Dispositif de mémorisation métal-isolant-semiconducteur dynamique, comprenant un circuit de suramplification selon l'une quelconque des revendications précédentes, comprenant en outre;

un circuit de synchronisation (21) produisant lesdits premier et deuxième signaux en réponse à un signal d'accès en mémoire (RAS); et une ligne de mot (WL) fonctionnellement connectée à ladite borne de sortie par l'intermédiaire d'un décodeur (22), ledit signal de sortie présent sur ladite borne de sortie étant fourni à ladite ligne de mot.

# Fig. 1

# Fig. 2

Fig. 3

2

# Fig. 4

Fig. 5

EP 0 202 025 B1

# Fig. 6